(19) Europäisches Patentamt
European Patent Office
Office européen des brevets

(11) **EP 4 050 328 A1**

(12) **EUROPEAN PATENT APPLICATION**

(43) Date of publication:
**31.08.2022 Bulletin 2022/35**

(21) Application number: **21159169.8**

(22) Date of filing: **25.02.2021**

(51) International Patent Classification (IPC):
**G01N 21/956** (2006.01)   **G03F 7/20** (2006.01)
**G05B 19/418** (2006.01)   **G06N 20/00** (2019.01)
**H01L 21/66** (2006.01)

(52) Cooperative Patent Classification (CPC):
**G03F 7/705; G03F 7/70508; G03F 7/70525;
G03F 7/70616; G03F 7/70633; G03F 7/70658;
G05B 19/418; G05B 19/41875; G05B 19/41885;
G06N 20/00; H01L 22/20**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **DOS SANTOS GUZELLA, Thiago
5500 AH Veldhoven (NL)**

• **ISHIBASHI, Masashi
5500 AH Veldhoven (NL)**
• **SANNO, Noriaki
5500 AH, Veldhoven, (NL)**
• **BASTANI, Vahid
5500 AH Veldhoven (NL)**
• **SAHRAEIAN, Reza
5500 AH Veldhoven (NL)**
• **SAPUTRA, Putra
5500 AH Veldhoven (NL)**

(74) Representative: **ASML Netherlands B.V.
Corporate Intellectual Property
P.O. Box 324
5500 AH Veldhoven (NL)**

(54) **METHOD TO PREDICT METROLOGY OFFSET OF A SEMICONDUCTOR MANUFACTURING PROCESS**

(57)   Described is a method for determining a spatially varying process offset for a lithographic process, the spatially varying process offset varying over a substrate subject to the lithographic process to form one or more structures thereon. The method comprises obtaining a trained model, having been trained to predict first metrology data based on second metrology data, wherein the first metrology data is spatially varying metrology data which relates to a first type of measurement of said structures being a measure of yield and said second metrology data is spatially varying metrology data which relates to a second type of measurement of said structures and correlates with said first metrology data; and using said model to obtain said spatially varying process offset.

Fig. 4

**EP 4 050 328 A1**

**Description**

FIELD

The present invention relates to semiconductor manufacturing processes, in particular metrology methods related to such semiconductor manufacturing processes.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

These tight control loops are generally based on metrology data obtained using a metrology tool measuring characteristics of the applied pattern or of metrology targets representing the applied pattern. In general the metrology tool is based on optical measurement of the position and/or dimensions of the pattern and/or targets. It is intrinsically assumed that these optical measurements are representative for a quality of the process of manufacturing of the integrated circuits.

In addition to control based on optical measurements, also scanning electron microscope based measurements may be performed; among which a so-called low voltage measurement using an e-beam tool (as offered by HMI) may be utilized. Such a low voltage contrast measurement is indicative of the quality of electrical contact between layers applied to the substrate.

Typically after all process steps have been completed each die on the substrate should be suitable to yield a functional semiconductor device (IC). In principle before further packaging of the IC is pursued each die is subject to electrical testing using various techniques, among which electrical probing. Electrical probing is normally done at multiple locations across the die, measuring multiple electrical properties (for example voltage, resistance, frequency). The probe values are a good indicator of the quality of the IC; for example when a measured resistance is very high this may indicate that electrical contact between components is not achieved and hence chances are very low that the IC will be functional. If testing of the electrical properties of the substrates conveys a large number of non-functional ICs it may be assumed that the manufacturing process has a low yield.

It has been usually observed that there is an offset, referred to as metrology-to-device offset, between the probe measurements and other metrology (e.g., overlay metrology) measurements obtained using an SEM tool or scatterometry tool, such that the best observed yield may not necessarily correspond to zero overlay. It would be desirable to improve present methods for determining this offset.

SUMMARY

In a first aspect of the invention there is provided a method for determining a spatially varying process offset for a lithographic process, said spatially varying process offset varying over a substrate subject to the lithographic process to form one or more structures thereon, the method comprising: obtaining a trained model, having been trained to predict first metrology data based on second metrology data, wherein the first metrology data is spatially varying metrology data which relates to a first type of measurement of said structures being a measure of yield and said second metrology data is spatially varying metrology data which relates to a second type of measurement of said structures and correlates with said first metrology data; and using said model to obtain said spatially varying process offset.

BRIEF DESCRIPTION OF THE DRAWINGS

Embodiments of the invention will now be described, by way of example only, with reference to the accompanying schematic drawings, in which:

Figure 1 depicts a schematic overview of a lithographic apparatus;
Figure 2 depicts a schematic overview of a lithographic cell;
Figure 3 depicts a schematic representation of holistic lithography, representing cooperation between three key technologies to optimize semiconductor manufacturing;
Figure 4 is a flow diagram of a method for determining a non-zero offset according to an embodiment of the invention; and
Figure 5 is a plot of overlay data against probe data illustrating a method for determining a non-zero offset according to an embodiment of the invention.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:

- a programmable mirror array. More information on such mirror arrays is given in U. S. Patent Nos. 5,296,891 and 5,523,193, which are incorporated herein by reference.
- a programmable LCD array. An example of such a construction is given in U. S. Patent No. 5,229,872, which is incorporated herein by reference.

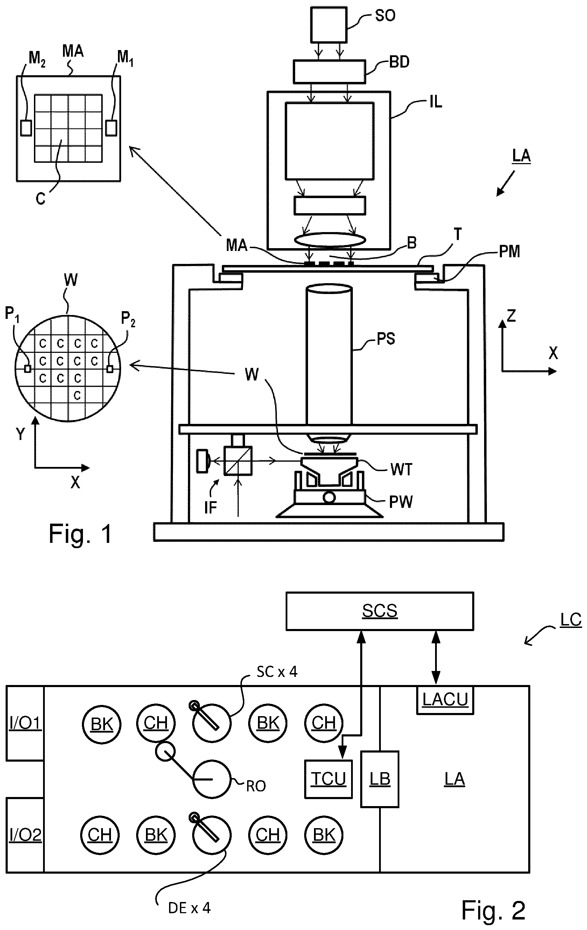

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support structure (e.g., a mask table) MT constructed to support a patterning device (e.g., a mask) MA and connected to a first positioner PM configured to accurately position the patterning device MA in accordance with certain parameters, a substrate table (e.g., a wafer table) WT constructed to hold a substrate (e.g., a resist coated wafer) W and connected to a second positioner PW configured to accurately position the substrate in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illuminator IL receives a radiation beam from a radiation source SO, e.g. via a beam delivery system BD. The illumination system IL may include various types of optical components, such as refractive, reflective, magnetic, electromagnetic, electrostatic, or other types of optical components, or any combination thereof, for directing, shaping, or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system" PS.

The lithographic apparatus may be of a type wherein at least a portion of the substrate may be covered by a liquid having a relatively high refractive index, e.g., water, so as to fill a space between the projection system and the substrate - which is also referred to as immersion lithography. More information on immersion techniques is given in U. S. Patent No. 6,952,253, which is incorporated herein by reference.

The lithographic apparatus LA may also be of a type having two (dual stage) or more substrate tables WT and, for example, two or more support structure MT (not shown). In such "multiple stage" machines the additional tables / structures may be used in parallel, or preparatory steps may be carried out on one or more tables while one or more other tables are being used for exposing the design layout of the patterning device MA onto the substrate W.

In operation, the radiation beam B is incident on the patterning device (e.g., mask MA), which is held on the support structure (e.g., mask table MT), and is patterned by the patterning device MA. Having traversed the mask MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and possibly another position sensor (which is not explicitly depicted in Figure 1) may be used to accurately position the mask MA with respect to the path of the radiation beam B. Mask MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks).

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

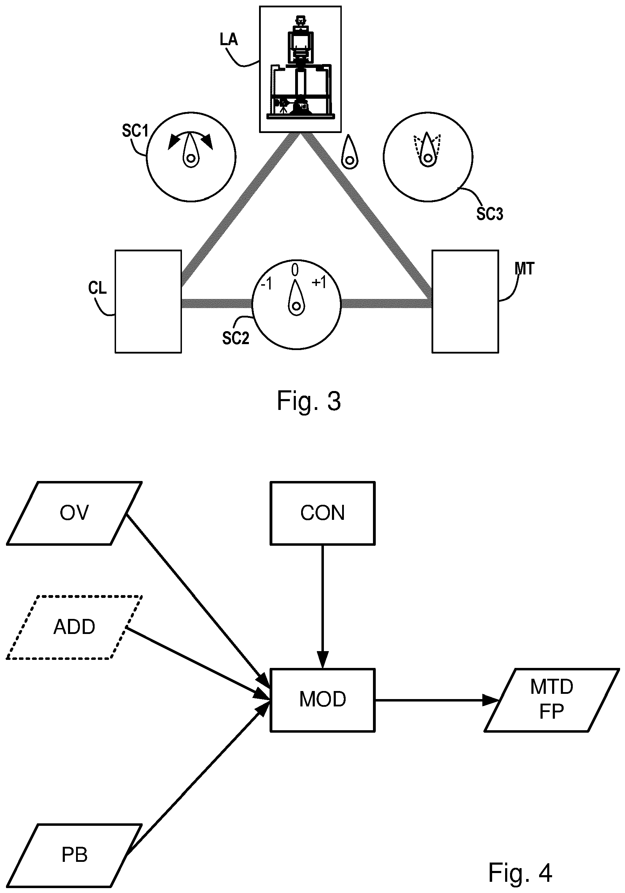

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double white arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT), so as to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

The lithographic apparatus LA is configured to accurately reproduce the pattern onto the substrate. The positions and dimensions of the applied features need to be within certain tolerances. Position errors may occur due to an overlay error (often referred to as "overlay"). The overlay is the error in placing a first feature during a first exposure relative to a second feature during a second exposure. The lithographic apparatus minimizes the overlay errors by aligning each wafer accurately to a reference prior to patterning. This is done by measuring positions of alignment marks on the substrate using an alignment sensor. More information on the alignment procedure can be found in U.S. Patent Application Publication No. US20100214550, which is incorporated herein by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus minimizes these focal positon errors by measuring the substrate surface topography prior to patterning using a level sensor. Substrate height corrections are applied during subsequent patterning to assure correct imaging (focusing) of the patterning device onto the substrate. More information on the level sensor system can be found in U.S. Patent Application Publication No. US20070085991, which is incorporated herein by reference.

Besides the lithographic apparatus LA and the metrology apparatus MT other processing apparatus may be used during IC production as well. An etching station (not shown) processes the substrates after exposure of the pattern into the resist. The etch station transfers the pattern from the resist into one or more layers underlying the resist layer. Typically etching is based on application of a plasma medium. Local etching characteristics may, for example, be controlled using temperature control of the substrate or directing the plasma medium using a voltage controlled ring. More information on etching control can be found in international Patent Application Publication No. WO2011081645 and U.S. Patent Application Publication No. US 20060016561 which are incorporated herein by reference.

During the manufacturing of the ICs, it is of great importance that the process conditions for processing substrates using processing apparatus, such as the lithographic apparatus or etching station, remain stable such that properties of the features remain within certain control limits. Stability of the process is of particular importance for features of the functional parts of the IC, i.e., the product features. To guarantee stable processing, process control capabilities need to be in place. Process control involves monitoring of processing data and implementation of means for process correction, e.g. control the processing apparatus based on characteristics of the processing data. Process control may be based on periodic measurement by the metrology apparatus MT, often referred to as "Advanced Process Control" (further also referenced to as APC). More information on APC can be found in U.S. Patent Application Publication No. US20120008127, which is incorporated herein by reference. A typical APC implementation involves periodic measurements on metrology features on the substrates to monitor and correct drifts associated with one or more processing apparatus. The metrology features reflect the response to process variations of the product features.

The term fingerprint may refer to a main (systematic) contributor ("latent factor") of a measured signal, and in particular a contributor connected to the performance impact on-wafer or to previous processing steps.

Such a fingerprint can refer to substrate (grid) patterns (e.g. from alignment, leveling, overlay, focus, CD), field patterns (e.g., from intrafield alignment, leveling, overlay, focus, CD), substrate zone patterns (e.g., outermost radius of wafer measurements) or even patterns in scanner measurements related to wafer exposure (e.g., heating signature through-lot from reticle alignment measurements, temperature/pressure/servo profiles, etc.). As such, each fingerprint may comprise a description of the spatial variation of a parameter of interest over a wafer or portion thereof (e.g., field or die). Fingerprints may be comprised within a fingerprint collection, and may be encoded homogenously or heterogeneously therein.

In practice, it is often necessary to derive a denser map of values from a sparse set of measurement values relating to a process parameter (across a substrate or plurality of substrates). Typically such a dense map of measurement values may be derived from the sparse measurement data in conjunction with a model associated with an expected fingerprint of the process parameter. More information on modeling measurement data can be found in international Patent Application Publication No. WO 2013092106 which is incorporated herein by reference. As a semiconductor manufacturing process involves multiple processing apparatuses (lithographic apparatus, etching stations, etc.), it may be beneficial to optimize the process as a whole; e.g., take specific correction capabilities associated with individual processing apparatus into account. This leads to the perspective that control of a first processing apparatus may be (partly) based on known control properties of a second processing apparatus. This strategy is commonly referred to as co-optimization. Examples of such a strategy include joint optimization of a lithographic apparatus and a density profile of a patterning device, and joint optimization of a lithographic apparatus and an etching station. More information on co-optimization may be found in international Patent application, application No. PCT/EP2016/072852 and US. Patent provisional application No. 62/298,882 which are incorporated herein by reference.

In some process control situations, the control objective may be, for example, "number of dies in spec". This describes a yield driven process control parameter which aims to obtain a maximum number of functional products per batch of processed substrates. Typically a product is associated with a die on a substrate and, as such, yield based process control is referred to as based on a "dies-in-spec" criterion. This aims to maximize the number of dies within specification, rather than applying an averaged optimization across the substrate (e.g., a least-squares optimization based on a least squares minimization of focus difference from best focus across the substrate). As such, a "dies-in-spec" optimization may use prior knowledge of the product (the die layout) when optimizing a process parameter. A least squares optimization typically treats each location equally, without taking into account the die layout. As such, a least squares optimization may prefer a correction which "only" has four locations out-of-specification, but each in a different die, over a correction which has seven locations out-of-specification, but only affecting two dies (e.g., four defects in one die, three in another). However, as a single defect will tend to render a die defective, maximizing the number of defect-free dies (i.e., dies-in-spec) is ultimately more important than simply minimizing the number of defects per substrate. A dies-in-spec optimization may comprise a maximum absolute (max abs) per die optimization. Such a max abs optimization may minimize the maximum deviation of the performance parameter from a control target. A differentiable approximation for the max abs function could be used instead, so that the cost function is easier to solve. For this to be effective, detail such as the wafer map should be used in the optimization. More information on yield based control may be found in European patent application EP16195819.4, which is incorporated herein by reference.

A relatively new technology area is the domain of machine learning. Methods relating to this technology are nowadays used to improve prediction of process parameters based on recognition of patterns present within the acquired data. Additionally machine learning techniques may be useful to guide the user in selecting the data that is most useful for process control purposes.

Electrical measurement data (e.g., probe data) may typically be obtained after processing of substrates. Typically, when performing electrical metrology to obtain the electrical measurement data, all the dies on the substrates are measured using probes which make (near) contact to the circuits formed during the processing. Various types of measurements may be performed; voltage, current, resistance, capacitance and inductance measurements, for example. These measurements may be performed under different conditions (frequencies, voltage, current for example) and at a plurality of locations across the die. An electrical measurement associated with a certain measured parameter (current, voltage, resistance, capacitance, inductance) at a certain condition may be represented by a plurality of graphs, each graph representing a spatial distribution of values associated with the measured parameter. The distribution of the measurement locations for which the electrical measurements need to be performed may not be constant, but may also depend on the relative position of the die on the substrate. Dies at the edge of the substrate may be more likely to have electrical defects, hence these dies may be sampled more densely than dies closer to the center of the substrate. Analogously, critical regions may be present within a die, such as those associated with functional logic structures, while less critical regions may be present, for example, at the periphery of the die. It is advantageous to provide denser electrical measurement sample schemes at the critical regions of the dies than at the less demanding regions.

The properties (minimum value, maximum value, variance or any other statistical measure) of the measured electrical characteristics are important indicators regarding the probability that a certain circuit on a die will be functional. Hence a strong relationship exists between the electrical characteristic and the yield of the process. Hence for yield control, electrical characteristic measurements are important. However, they are also time consuming and are only performed at the end stage of the semiconductor manufacturing process (e.g. when options for correcting non-functional circuits are virtually absent).

Semiconductor manufacturing depends on a series of interlocked feedback loops (e.g., the APC loops described above and others) which control production to minimize variation and ensure that key performance indicators are within bounds. To achieve this, methods to estimate and account for systematic measurement errors may be used. In the example of overlay, these are important to account for differences or inaccuracies in measurements between ADI (after-develop inspection) and AEI (after-etch inspection), and also to account for differences between AEI and probe data (electrical characteristic data). In this context, the terms process offset or MTD (Metrology-to-Device) offset are often used synonymously to refer to these systematic errors, whether between ADI and AEI (AEI-ADI MTD), or between AEI and probe (MTD with respect to probe).

Of special interest is the case of the MTD with respect to probe, which relates AEI overlay to a particular yield parameter. In this case, a MTD effect is manifested when the best observed yield is obtained for an AEI overlay value that is different from zero. At present, this may be calibrated by analyzing the overlay data and probe data irrespective of the location on the wafer for a measurement, and inferring the dependence of probe data on overlay. For this, one approach may comprise fitting a second-order polynomial on the overlay data to predict probe data, and estimating the MTD as the minimum value of the function (i.e., when the probe values are such that lower values indicate better yield; in the converse scenario the MTD would be the maximum value of the function). Another approach could be to bin the overlay values, assigning all values within an interval as a single "group", and compute a summary statistic, such as the mean for each group, of the corresponding probe values. The MTD wrt probe can then be estimated by determining the overlay interval resulting in the best observed mean probe values. The single MTD value determined in either approach may be applied across each wafer as a "correction", such scanner control during exposure aims to control overlay towards the given MTD value rather than zero. In this case, since a single MTD value is estimated, assumed constant across the wafer, this is a translation-only estimate. Such a method is described, for example, in WO 2018/202361 which is hereby incorporated by reference.

Finally, AEI overlay may be measured using an SEM (Scanning Electron Microscope) or optical metrology tool (e.g., In-Device Metrology (IDM) using a scatterometer). The latter option is being increasingly used for these overlay measurements, since it can perform measurements faster such that more data is available for estimating the MTD wrt probe.

This approach for estimating the MTD from AEI to probe is very limited, since it results in only a single correction value across the wafer. In other words, it relies on an assumption that the MTD value does not depend on wafer location. This reflects a simplicity in the core estimation method being used (either the second-order polynomial or the binning approach). It also reflects the expectation that, given the usually limited sample size (number of wafers measured) and the noisy nature of the data, a translation-only correction may be sufficient to account for some of the impact of systematic measurement errors. This is a very conservative approach, seeking to minimize the impact of the uncertainty in estimating the MTD offset value; as such, it does not fully capture all the possible gains that may be obtained when optimally correcting the differences between AEI overlay and probe data.

In addition, the two core estimation methods currently used have shortcomings. When using a second-order polynomial fit to overlay, no additional constraints are used. A consequence of this is that sometimes the estimated dependence of probe values on overlay is the opposite to what would be expected: as the absolute overlay value increases indefinitely, the probe values improve indefinitely. This happens due to the combination of variation in the data and small sample size, given the lack of constraints in fitting the model. The binning approach for estimation, on the other hand, requires manual tuning based on the data, to find an appropriate binning for the overlay values, which is cumbersome and time-consuming.

It is therefore proposed to use a general machine learning model to estimate a wafer-location dependent (or spatially variant) MTD (e.g., MTD wrt probe), which has been trained on overlay data and probe data. Optionally, additional data such as critical dimension (CD) data, wafer thickness data, leveling data, context data, alignment data or other suitable data may be used for training and estimation, if available.

The concepts will be described predominately in terms of determining an a spatially variant overlay MTD offset, however the concepts are not limited to overlay as the MTD parameter. The concepts may be applied to any other parameter which is impacted by a spatially variant MTD offset. For example, the proposed methods may be used to determine MTD for dose, for example in the context of critical dimension control. Such an embodiment may be used to derive an MTD dose map for a dose mapping application. As such, any mention of overlay, overlay data, overlay map and a model which maps overlay to electrical characteristic or probe data should be understood to encompass disclosure of other parameters, other parameter data, other parameter maps and a model which maps the other parameter to electrical characteristic or probe data, where the other parameter may be dose by way of example.

In an embodiment, where AEI metrology data is available, a complete MTD wrt probe determination may comprise determining the AEI MTD offset with respect to probe ($MTD_{AEI-probe}$) using the methods disclosed herein based on AEI metrology (e.g., overlay) data. This can then be combined (e.g., summed) with an AEI MTD ($MTD_{ADI-AEI}$) offset to determine a total MTD offset. $MTD_{ADI-AEI}$ offset may be the difference/offset between ADI metrology (e.g., overlay) data and AEI metrology (e.g., overlay) data. This $MTD_{ADI-AEI}$ offset may be determined as a spatially variant offset (at any suitable level of granularity or spatial scale, e.g., per field or per die) or a translation offset depending on the available data. Alternatively, where no AEI metrology data is available, the methods disclosed herein may be applied directly to the ADI metrology data to determine the MTD wrt probe as an $MTD_{ADI-probe}$ offset.

The method may comprise obtaining a model which has been trained to map overlay and (optionally) additional process data (e.g., CD, context data, wafer thickness data) to electrical characteristic or probe data (e.g., a yield proxy). Alternatively the impact of any additional process data may be accounted for, indirectly, via constraints on the model. This model can then be used to find a spatially variant (position dependent) MTD offset (map). The MTD offset map may be determined based on a yield optimization of the model (e.g., to find the MTD offset map which optimizes yield).

The model may have adjustable spatial resolution by aggregating metrology data (and the optional additional process data) at a selectable spatial scale (e.g., per wafer/field/die/point). This enables statistical analysis of MTD offset uncertainty versus granularity and may effectively achieve choosing a spatial scale (MTD offset map resolution) based on the volume (and/or quality) of metrology data available (e.g., a higher resolution MTD offset map for a larger volume of metrology data and the converse).

The model may be subject to constraints; for example a constraint may be imposed which results in a well-defined problem and unique solution for the MTD offset. The constraint may be that the model function is constrained to be convex with respect to overlay, and where used, also the additional process data. This assumes that a lower probe value corresponds to better yield; in the converse situation where a higher probe value corresponds to better yield, the function may be constrained to be concave for the same effect. The model class may also be chosen based, for example, on its suitability for, and relative simplicity in, imposing such a constraint. Such a model may comprise, for example, a second order polynomial or C-spline model. Any other model which facilitates imposing convexity/concavity may of course be used.

Other constraints may comprise imposing smoothness so as to reduce magnitude of MTD offset variation between neighboring regions (e.g., points, dies or fields depending on the model's chosen spatial scale). Smoothness may be imposed in a number of ways, e.g., imposing a maximum difference between MTD offset of neighboring regions. The MTD offset may also have a constrained magnitude (e.g., to be constrained within bounds). Examples of the type of model and possible constraints will be described in further detail below.

The model may also be used to estimate (per die for example) potential yield improvement resultant from imposition of the determined MTD offset. For example, the MTD offset may be applied to the overlay data and the model then used to predict probe/yield performance based on the corrected overlay data. The model may be used to monitor whether the MTD offset changes over time. If it is determined the MTD offset has changed significantly, then the MTD offset value may be updated and/or a further full MTD offset calibration triggered, or and/or other diagnostic steps performed.

Because the modeling approach disclosed herein is disclosed generally, the model encompasses and formalizes the practical approach currently used for determining MTD offset (estimation of a translation-only value, by fitting a second order polynomial or applying the binning method to the entire data as has been described). The modeling approach may also include more general scenarios in which the MTD offset fingerprint is allowed to vary throughout the wafer. In doing so, the problem is described according to a solid statistical foundation, allowing for well-founded comparisons between different model instantiations. In this way, the MTD offset correction better reflects the interplay between the amount of data available and the physical properties of the process, to enable better capture of the achievable yield gains.

Figure 4 is a flow diagram describing a possible method. First metrology data or overlay data OV and second metrology data or electrical characteristic/probe data PB is fed into a machine learning model MOD. Optionally, additional process data ADD may also be fed into the model MOD. The problem of estimating the MTD offset fingerprint may be framed as that of determining the relationship between overlay data and probe data across the wafer, optionally accounting for additional processes data or variables. Therefore, subject to constraints CON, the model learns to map the overlay data OV (and the additional process data ADD when provided) to the probe data PB.

Once this relationship has been determined, the trained model MOD may be used to estimate the MTD offset fingerprint MTD FP at a spatial scale of choice. For example, the MTD offset value for each location may be estimated by determining, for each location in the wafer, the overlay value which results in the best expected probe value (i.e., the probe value most indicative of yield) as predicted by the model . By properly constraining the model (e.g., to a convex relationship), a unique solution for the best expected probe value may be assured. Other constraints may be used to capture domain knowledge and/or to limiting the magnitude of the final MTD offset values to a given range.

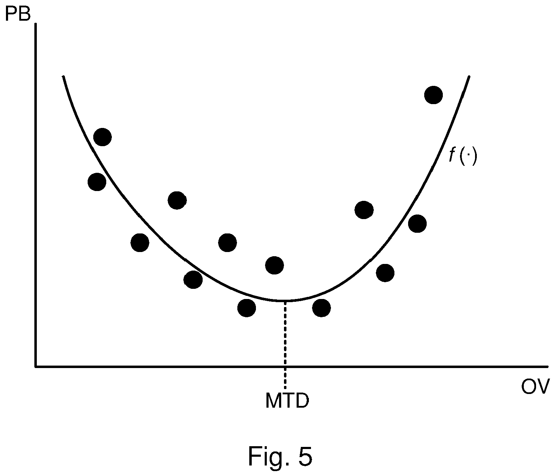

Figure 5 illustrates an example relationship between overlay OV (input) and probe PB (output) values (lower probe values correspond with better performance) for a particular location (e.g., die or field) $i$. The dots represent the actual data, and the learned or fitted relationship is described by function $f(\cdot)$, here a second order convex polynomial. The MTD offset for the location i in this embodiment may be defined as the overlay value corresponding to the minimum probe value according to function $f(\cdot)$ for this location.

As has been briefly discussed, the problem may be formalized by considering the spectrum of possible scenarios, based on the wafer layout for the product of interest. The general model may posit that the relationship between overlay and probe depends on the (e.g., die) location on the wafer, accounting for any type of dependence on location. In this way, it encompasses a spectrum of possible scenarios. These scenarios may range from a first extreme, when data from all locations are analyzed together, without any dependence on location, to obtain a single MTD offset value for all locations (coarsest-grained MTD offset fingerprint). This will be a translation-only fingerprint, but with the added flexibility (compared to present methods) of allowing for a different parameterization of the relationship between overlay and probe, and the ability to impose one or more constraints. The second extreme may be equivalent to analyzing the data from each location individually, i.e., completely separately from the other location data, such that the MTD offset value is estimated independently of the data from the other locations. This is the finest-grained MTD offset fingerprint, since it is allowed to freely vary, in the sense that the MTD offset values for two nearby locations in the wafer may be very different. As this will be the most complex model, it is expected that it requires the greatest amount of data for reliable estimates. Between these extremes, the spatial scale may be varied (e.g., per multiple fields, per field, per multiple dies, per die, per die functional area (sub-die area) or per location (e.g., in the latter two cases, where more than one probe measurement is performed per die)).

It may be that an intermediate spatial scale (e.g., per-field) is preferred over smaller scales for a number of reasons. Such reasons may include a better averaging over noise to obtain better behaved estimates. Model uncertainty may also be improved with a per-field spatial scale over smaller scales, albeit at the cost of sensitivity. A spatially variant MTD offset determined at a per-field scale is also simpler to actuate by the scanner.

While the description above describes determining the spatial variation of the MTD offset value itself, the modeling can be extended to the relationship between overlay and probe data. In other words, the specific model used to model how this relationship varies across the wafer, which in turn can be used to determine the MTD offset fingerprint.

It can be appreciated that, while the core problem may be formulated on a determination of the relationship between overlay and probe data, it is expected that the ultimate performance requirements are not as stringent when the variable of interest is the MTD offset value compared to predicting the probe value given overlay data (e.g., as described in WO 2018/202361). For example, it may be that, given the estimated relationship between overlay and probe, the overall prediction performance for probe values is low, but it is still possible to reliably estimate the MTD offset value. In addition, by leveraging the entire data for analysis in a single model, statistical strength from the data from multiple locations is leveraged. In addition, the model may be made more robust by the imposition of constraints on the model, e.g., using domain knowledge.

In a more specific example, the mapping of overlay data $o$ and any (optional) additional process data $r$ to probe data $u$ in a wafer location indexed by $i$ may be described by a function $f(\cdot)$ parameterized by model parameters $\theta_i$. For simplicity, in this example additional sources of variation, *inter alia* time or lot, are not accounted for, though they could easily be incorporated in this formulation. For simplicity it is also assumed that the same class of function $f(\cdot)$ is used for all locations, though that does not necessarily need to be the case; for example, it could be of interest to define a more restrictive function type for the inner-region of the wafer, and a more flexible function for the edge region. As defined in the current simplified example, the model may take the general form of:

$$u = f(o, \ r \mid \theta_i)$$

The model parameterization $\theta_i$ may define the structure of the model in such a way that the spatial scale may be specified. For example, the spatial scale may be chosen at a field level, such that the same relationship is defined for all die locations within each field, at a die level, with an effect per field plus an additive intrafield effect, or one of many other scenarios.

Depending on the specific model used, one or more different options may be employed to control the spatial smoothness of function $f(\cdot)$ and the estimated MTD offset values, as will be further described below. Once this parameterization has been defined, additional constraints, informed by domain knowledge, may be added.

In the following example, it is assumed that the probe values used are such that a lower value indicates better yield, without loss of generality. In this case, the function $f(\cdot)$ may be constrained to be convex with respect to overlay, and also the additional process data (or concave where higher probe values indicate better yield). This arises from a domain point of view, analogous to the concept of a process window, and also from a statistical point of view, to enforce smoothness of the function and ensure that the estimated MTD offset value is relatively well-defined and unique.

The MTD offset wrt probe $v_i$ may be determined using the trained model according to a minimization (based on the assumption that lower value indicates better yield) of the expected probe value $E[f(o,r|\theta_i)]$ according to the model; e.g.,:

$$v_i = \arg\min_o E[(o, r \mid \theta_i)]$$

It can be seen that, in this simplified model example leading to MTD offset optimization, the spatial variation is handled by the model parameters (since the same function type is used for all locations in the wafer), while the overlay data/additional process data is aggregated in accordance with the desired spatial scale. The location i may be a die location, a field location etc., depending on the spatial scale.

In this example the same function is used for all locations i, and all spatial variation in the overlay-probe relationship is handled by the model parameters. As has been described, if different functions are used for different regions (for example, 2nd order polynomial for inner regions of the wafer, and C-spline for edge regions), then the spatial variation is handled by the combination of model parameters per location and the variation in type of function.

The specific form of function $f(\cdot)$ may be such that it allows the convex/concave function constraint to be applied with relative simplicity. Another factor in choosing a suitable form is how the wafer position should be accounted for, to control the smoothness of the resulting MTD offset estimates. A couple of specific examples will now be described, based on a simplified scenario using only overlay data for a single layer and single direction, so that overlay parameter $o$ is a scalar, and the probe value $u$ is also a scalar. In this case, function $f(\cdot)$ may be defined as either:

- a second-order polynomial in $o_{i,j}$, e.g.: $f(o, \ r|\theta_i) = a_i o^2 + b_i o + c_i$ where $\theta_i = [a_i, \ b_i, \ c_i]^\mathsf{T}$
- C-splines given $o$, e.g., using methods as described in either of the following publications, which are incorporated herein by reference: Mary C. Meyer. (2012) Constrained penalized splines, The Canadian Journal of Statistics, 40(1), pp. 190-206 and H. Maatouk & X. Bay. (2017). Gaussian process emulators for computer experiments with inequality constraints. Mathematical Geosciences 49 (5), pp. 557-582.

From that choice, the structure of the model, which relates spatial effects and other potential variables of interest to the parameters $\theta_i$, may be defined based on hierarchical modeling built from:

- standard linear regression on wafer layout variables, such as field and intrafield locations.

- using Gaussian processes [e.g., as described in C. E. Rasmussen & C. K. I. Williams (2006). Gaussian Processes for Machine Learning. MIT Press, incorporated herein by reference]. Such an approach may account for the wafer layout variables by different Gaussian processes and/or the specific kernel covariance function used. Such a Gaussian process may leverage the entire data set at once rather than treating each region separately to obtain a smoothly varying MTD offset over the wafer.

Suitable hierarchal modeling methods are described, for example, in A. Gelman, J. B. Carlin, H. S. Stern, D. B. Dunson, A. Vehtari & D. B. Rubin (2013). Bayesian Data Analysis. 3rd edition. Taylor & Francis, which is incorporated herein by reference.

The resulting model may be implemented under a standard optimization setting, in which model fitting is performed by directly minimizing a cost function under the respective constraints, or under a probabilistic setting, in which priors on the model parameters are specified. Once the model(s) of interest have been specified and fit to the data, they can be compared using standard model comparison and selection criteria, to select the most appropriate model.

In all the above, computational metrology may be performed to generate suitably dense overlay maps for an expected overlay range, using models of intra wafer and intra field overlay in combination with results of actual overlay metrology (e.g., AEI and/or ADI metrology). The electrical characteristic data may comprise bitmap data (e.g., for memory ICs) such as obtained from electrostatic discharge testing, the aforementioned electrical probe tests, scan fault isolation tests etc..

There are a number of applications for the spatially variant MTD offset (MTD offset map) as determined using the methods disclosed herein. A first application may be control of the lithographic process (e.g., scanner control). The MTD offset generated with respect to probe can be used for control of scanner exposure, e.g., to apply an appropriate overlay and/or dose (or other parameter) offset for overlay and/or dose control during the exposure.

Other applications include:

- Recipe verification/"qualification" of metrology tools (e.g., for overlay: AEI IDM metrology tool and/or ADI metrology tool; or for CD (dose map): SEM/e-beam metrology tool).
- Monitoring of ongoing production to determine whether applied probe MTD offset is within limits; if it is detected that the MTD offset has changed, this may be used to trigger a re-calibration of the MTD offset.

Further embodiments are disclosed in the list of numbered clauses below:

1. A method for determining a spatially varying process offset for a lithographic process, said spatially varying process offset varying over a substrate subject to the lithographic process to form one or more structures thereon, the method comprising: obtaining a trained model, having been trained to predict first metrology data based on second metrology data, wherein the first metrology data is spatially varying metrology data which relates to a first type of measurement of said structures and is indicative of yield and said second metrology data is spatially varying metrology data which relates to a second type of measurement of said structures and correlates with said first metrology data; and using said model to obtain said spatially varying process offset.

2. A method according to clause 1, comprising training said model using said first metrology data and second metrology data.

3. A method according to clause 1 or 2, wherein the first metrology data comprises electrical characteristic data describing an electrical characteristic of said structures.

4. A method according to clause 3, wherein the first type of measurement comprises one or more of electrostatic discharge measurement, electrical probe measurement, scan fault isolation measurement.

5. A method according to any preceding clause, wherein the second metrology data comprises overlay data.

6. A method according to clause 5, wherein the overlay data comprises one or more of after-develop overlay data measured prior to a processing step and after-etch overlay data measured after said processing step.

7. A method according to clause 5 or 6, wherein the spatially varying process offset is an overlay offset to be used as a desired overlay value during said lithographic process.

8. A method according to any of clauses 1 to 4, wherein the second metrology data comprises dose data.

9. A method according to clause 8, wherein the spatially varying process offset is a dose offset to be used as a desired dose value during said lithographic process.

10. A method according to any of clauses 5 to 9, wherein the second metrology data further comprises additional process data relating to a parameter other than overlay or dose.

11. A method according to clause 10, wherein the additional process data comprises one or more of: critical dimension (CD) data, wafer thickness data, leveling data, context data, alignment data.

12. A method according to any preceding clause, wherein said model has a variable spatial resolution such that the spatial scale of said spatially varying process offset can be varied.

13. A method according to clause 12, wherein said model aggregates said second metrology data in accordance with a desired spatial scale for said spatially varying process offset.

14. A method according to clause 13 or 14, wherein said spatial scale is variable between at least: measurement location level, die level, field level, multiple-field region level.

15. A method according to clause 14, wherein said spatial scale is further variable up to substrate level.

16. A method according to any preceding clause, wherein the model is constrained to comprise a convex function between said first metrology data and second metrology data when a value indicative of best performance is a minimum for the variable corresponding to the first metrology data; or a concave function between said first metrology data and second metrology data when a value indicative of best performance is a maximum for the variable corresponding to the first metrology data.

17. A method according to any preceding clause, wherein the step of using said model to obtain said spatially varying process offset comprises determining, for each location, a parameter value corresponding to an expected value indicative of best performance for the variable corresponding to the first metrology data according to said model.

18. A method according to any preceding clause, wherein said model comprises a second order polynomial function or C-spline model.

19. A method according to any preceding clause, wherein said spatially varying process offset comprises an offset between a nominal optimal parameter value as measured by a metrology device and an actual optimal parameter value which optimizes yield.

20. A method according to any preceding clause, wherein one or more constraints can be imposed on the model.

21. A method according to clause 20, wherein a smoothness constraint is imposed on the model so as to impose smoothness in the variation of the said spatially varying relationship between values corresponding to the first metrology data and second metrology data, and/or to impose smoothness in the variation of said spatially varying process offset.

22. A method according to clause 21, wherein said smoothness constraint imposes a maximum difference between the spatially varying process offset of neighboring locations.

23. A method according to any of clauses 20 to 22, wherein a magnitude constraint is imposed such that the magnitude of the spatially varying process offset is maintained below an upper bound and/or above a lower bound.

24. A method according to any preceding clause, wherein the model is structured to output a smoothly spatially varying process offset.

25. A method according to clause 24, wherein the model uses a Gaussian Process prior and/or specific kernel covariance function to relate spatial variation to model parameters of said model.

26. A method according to any of clauses 1 to 24, wherein the model uses a linear regression to relate spatial variation to model parameters of said model.

27. A method according to any preceding clause, comprising using said model to estimate a potential yield improvement resultant from imposition of the determined spatially varying process offset.

28. A method according to clause 27, comprising applying the spatially varying process offset to the second metrology data; using the model to predict first metrology data based on the corrected second metrology data; and predicting yield based on the predicted first metrology data.

29. A method according to any preceding clause, further comprising controlling the lithographic processing process for subsequent substrates based on said spatially varying process offset.

30. A computer program comprising instructions for a processor which cause the processor to perform the method of any preceding clause.

31. A processing device and associated program storage, said program storage comprising instructions for the processor which cause the processor to perform the method of any of clauses 1 to 29.

32. A lithographic apparatus and/or metrology apparatus comprising the processing device and associated program storage of clause 31.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method for determining a spatially varying process offset for a lithographic process, said spatially varying process offset varying over a substrate subject to the lithographic process to form one or more structures thereon, the method comprising:

   obtaining a trained model having been trained to predict first metrology data based on second metrology data, wherein the first metrology data is spatially varying metrology data which relates to a first type of measurement on said structures being a measure of yield and said second metrology data is spatially varying metrology data which relates to a second type of measurement on said structures and correlates with said first metrology data; and
   using said model to obtain said spatially varying process offset.

2. A method as claimed in claim 1, comprising training said model using said first metrology data and second metrology data.

3. A method as claimed in claim 1 or 2, wherein the first metrology data comprises electrical characteristic data describing an electrical characteristic of said structures.

4. A method as claimed in claim 3, wherein the first type of measurement comprises one or more of electrostatic discharge measurement, electrical probe measurement, scan fault isolation measurement.

5. A method as claimed in any preceding claim, wherein the second metrology data comprises overlay data.

6. A method as claimed in claim 5, wherein the overlay data comprises one or more of after-develop overlay data measured prior to a processing step and after-etch overlay data measured after said processing step.

7. A method as claimed in claim 5 or 6, wherein the spatially varying process offset is an overlay offset to be used as a desired overlay value during said lithographic process.

8. A method as claimed in any of claims 5 to 7, wherein the second metrology data further comprises additional process data relating to a parameter other than overlay or dose.

9. A method as claimed in any preceding claim, wherein said model has a variable spatial resolution such that the spatial scale of said spatially varying process offset can be varied.

10. A method as claimed in claim 9, wherein said model aggregates said second metrology data in accordance with a desired spatial scale for said spatially varying process offset.

11. A method as claimed in claim 9 or 10, wherein said spatial scale is variable between at least: measurement location level, die level, field level, multiple-field region level.

12. A method as claimed in any preceding claim, wherein the model is constrained to comprise a convex function between said first metrology data and second metrology data when a value indicative of best performance is a minimum for the variable corresponding to the first metrology data; or a concave function between said first metrology data and second metrology data when a value indicative of best performance is a maximum for the variable corresponding to the first metrology data.

13. A method as claimed in any preceding claim, wherein the step of using said model to obtain said spatially varying process offset comprises determining, for each location, a parameter value corresponding to an expected value indicative of best performance for the variable corresponding to the first metrology data according to said model.

14. A method as claimed in any preceding claim, wherein said spatially varying process offset comprises an offset between a nominal optimal parameter value as measured by a metrology device and an actual optimal parameter value which optimizes yield.

15. A method as claimed in any preceding claim, wherein a smoothness constraint is imposed on the model so as to impose smoothness in the variation of the said spatially varying relationship between values corresponding to the first metrology data and second metrology data, and/or to impose smoothness in the variation of said spatially varying process offset.

Fig. 1

Fig. 2

LA

SC1

SC3

CL

MT

-1    0    +1

SC2

Fig. 3

OV

CON

ADD

MOD

MTD
FP

PB

Fig. 4

Fig. 5

Europäisches
Patentamt

European
Patent Office

Office européen
des brevets

## EUROPEAN SEARCH REPORT

Application Number

EP 21 15 9169

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 2018/202361 A1 (ASML NETHERLANDS BV [NL]) 8 November 2018 (2018-11-08) | 1-11,13, 14 | INV. G01N21/956 |
| Y | * paragraphs [0050] - [0063]; figures 4,5 * <br> * paragraphs [0073] - [0081]; figures 7,8 * | 12,15 | G03F7/20 G05B19/418 G06N20/00 H01L21/66 |
| X | WO 2020/114686 A1 (ASML NETHERLANDS BV [NL]) 11 June 2020 (2020-06-11) <br> * paragraph [0029] * <br> * paragraphs [0041] - [0057]; figure 5 * | 1 | |
| Y | US 2017/200265 A1 (BHASKAR KRIS [US] ET AL) 13 July 2017 (2017-07-13) <br> * paragraphs [0071] - [0073] * <br> * paragraph [0078]; figures 1,2 * <br> * paragraphs [0088] - [0089] * <br> * paragraphs [0112] - [0117] * <br> * paragraph [0130] * | 12 | |
| Y | WO 2020/094325 A1 (ASML NETHERLANDS BV [NL]) 14 May 2020 (2020-05-14) <br> * paragraphs [0054] - [0086] * <br> * paragraphs [0145] - [0148] * | 15 | TECHNICAL FIELDS SEARCHED (IPC) <br><br> G01N <br> G05B <br> G06N <br> G03F <br> H01L |

The present search report has been drawn up for all claims

| Place of search | Date of completion of the search | Examiner |
|---|---|---|
| Munich | 6 August 2021 | van Toledo, Wiebo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 21 15 9169

This annex lists the patent family members relating to the patent documents cited in the above-mentioned European search report.
The members are as contained in the European Patent Office EDP file on
The European Patent Office is in no way liable for these particulars which are merely given for the purpose of information.

06-08-2021

| Patent document cited in search report | | Publication date | Patent family member(s) | | Publication date |
|---|---|---|---|---|---|
| WO 2018202361 | A1 | 08-11-2018 | CN | 110622069 A | 27-12-2019 |
| | | | KR | 20190139967 A | 18-12-2019 |
| | | | TW | 201843533 A | 16-12-2018 |
| | | | TW | 202014809 A | 16-04-2020 |
| | | | US | 2020103761 A1 | 02-04-2020 |
| | | | WO | 2018202361 A1 | 08-11-2018 |
| WO 2020114686 | A1 | 11-06-2020 | CN | 113168111 A | 23-07-2021 |
| | | | KR | 20210083348 A | 06-07-2021 |
| | | | TW | 202030652 A | 16-08-2020 |
| | | | WO | 2020114686 A1 | 11-06-2020 |
| US 2017200265 | A1 | 13-07-2017 | CN | 108463876 A | 28-08-2018 |
| | | | IL | 260101 A | 30-06-2020 |
| | | | KR | 20180095708 A | 27-08-2018 |
| | | | TW | 201734955 A | 01-10-2017 |
| | | | US | 2017200265 A1 | 13-07-2017 |
| | | | WO | 2017123555 A1 | 20-07-2017 |
| WO 2020094325 | A1 | 14-05-2020 | CN | 112969967 A | 15-06-2021 |
| | | | EP | 3807720 A1 | 21-04-2021 |
| | | | KR | 20210069104 A | 10-06-2021 |
| | | | TW | 202025329 A | 01-07-2020 |
| | | | TW | 202101633 A | 01-01-2021 |
| | | | US | 2021165399 A1 | 03-06-2021 |
| | | | WO | 2020094325 A1 | 14-05-2020 |

EPO FORM P0459

For more details about this annex : see Official Journal of the European Patent Office, No. 12/82

EP 4 050 328 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- US 5229872 A
- US 6952253 B
- US 20100214550 A
- US 20070085991 A
- WO 2011081645 A

- US 20060016561 A
- US 20120008127 A
- WO 2013092106 A
- EP 2016072852 W
- US 62298882
- EP 16195819
- WO 2018202361 A

**Non-patent literature cited in the description**

- **MARY C. MEYER.** Constrained penalized splines. *The Canadian Journal of Statistics,* 2012, vol. 40 (1), 190-206
- **H. MAATOUK ; X. BAY.** Gaussian process emulators for computer experiments with inequality constraints. *Mathematical Geosciences,* 2017, vol. 49 (5), 557-582

- **C. E. RASMUSSEN ; C. K. I. WILLIAMS.** Gaussian Processes for Machine Learning. MIT Press, 2006
- **A. GELMAN ; J. B. CARLIN ; H. S. STERN ; D. B. DUNSON ; A. VEHTARI ; D. B. RUBIN.** Bayesian Data Analysis. Taylor & Francis, 2013

18